# FASCICULE DE BREVET EUROPEEN

(11) **EP 4 354 524 B1**
(45) Date de publication et mention de la délivrance du brevet: **26.03.2025**
(21) Numéro de dépôt: 23203239.1
(22) Date de dépôt: 12.10.2023
(51) Int. Cl.: H10F 30/221, H10F 30/223, H10F 71/00

(54) **PHOTODIODE PLANAIRE À BASE DE GERMANIUM COMPORTANT UNE ZONE LATÉRALE PÉRIPHÉRIQUE EN COMPRESSION**
PLANARE PHOTODIODE AUF GERMANIUMBASIS MIT EINER KOMPRESSIVEN PERIPHEREN SEITLICHEN ZONE
GERMANIUM-BASED PLANAR PHOTODIODE COMPRISING A COMPRESSIVE PERIPHERAL LATERAL ZONE

(30) Priorité: 14.10.2022 FR 2210639
(43) Date de publication de la demande: 17.04.2024
(73) Titulaire: Commissariat à l'Energie Atomique et aux Energies Alternatives, 75015 Paris (FR)
(72) Inventeur: ALIANE, Abdelkader, Grenoble cedex 09 (FR); KAYA, Hacile, Grenoble cedex 09 (FR); MEHREZ, Zouhir, Grenoble cedex 09 (FR)
(74) Mandataire: Brevalex

(56) Documents cités:
- EP-A1- 3 657 556
- EP-A1- 3 806 167
- WO-A1-2019/202250

## Description

### DOMAINE TECHNIQUE

Le domaine de l'invention est celui des photodiodes planaires réalisées à base de germanium. L'invention trouve une application notamment dans le domaine de la détection d'un rayonnement lumineux dans le proche infrarouge.

### ÉTAT DE LA TECHNIQUE ANTÉRIEURE

Les dispositifs optoélectroniques de photodétection peuvent comporter une matrice de photodiodes planaires. Les photodiodes s'étendent alors suivant un même plan principal, entre des première et deuxième faces opposées et parallèles entre elles. Elles comportent alors chacune une portion de détection issue d'une même couche semiconductrice, formée par exemple d'une première région (semelle, *seed layer* en anglais) en germanium dopé p+ et affleurant la première face, d'une deuxième région (caisson) en germanium dopé n+ et affleurant la deuxième face, et d'une région intermédiaire en germanium intrinsèque ou très peu dopé p, et située entre les première et deuxième régions dopées. Cette région intermédiaire entoure la deuxième région dopée n+ dans le plan principal de la photodiode, et affleure la deuxième face. Une couche de passivation réalisée en un matériau diélectrique recouvre habituellement la deuxième face, et permet de limiter la contribution du courant d'obscurité au courant électrique mesuré par chaque photodiode.

Cette portion de détection peut être entourée d'une portion latérale périphérique, réalisée en un matériau électriquement conducteur, qui entoure la portion de détection dans le plan principal de la photodiode et vient au contact de la première région dopée p+. Cette portion latérale périphérique assure alors une fonction d'isolation optique avec les photodiodes planaires voisines et permet d'appliquer un potentiel électrique à la première région dopée p+ à partir de la deuxième face. Elle peut également permettre de générer des contraintes mécaniques en tension dans la portion de détection.

En effet, lorsque le matériau de la portion d'absorption est à base de germanium, il peut être mis en tension de manière à rendre sa structure de bandes d'énergie directe et non plus indirecte. De plus, la photodiode peut alors être adaptée à absorber un rayonnement lumineux jusqu'à une longueur d'onde de coupure supérieure à 1550nm, qui est la longueur d'onde de coupure d'absorption du germanium relaxé, pour une application notamment dans le proche infrarouge (SWIR, pour *Short Wavelength IR,* en anglais).

A ce titre, le document WO 2019/202250 A1 décrit un exemple d'une telle photodiode planaire, où la portion latérale périphérique est réalisée en un matériau piézoélectrique. La déformation de la portion latérale périphérique dans le plan principal, par effet piézoélectrique inverse, permet de mettre en tension la portion de détection.

Le document EP 3 806 167 A1 décrit un autre exemple de photodiode planaire. Ici, la portion latérale périphérique est réalisée en un matériau à base de silicium dopé p+. La mise en tension de la portion de détection est obtenue lors de la réalisation par épitaxie de la portion latérale périphérique, du fait du différentiel de dilatation thermique entre le germanium et le silicium.

Par ailleurs, il apparaît que la présence de la couche diélectrique de passivation peut malgré tout contribuer à générer un courant d'obscurité non négligeable. Ainsi, l'article de Sood et al. intitulé Characterization of SiGe-Detector Arrays for Visible-NIR Imaging Sensor Applications, Proc. of SPIE VOL. 8012, 801240, 2011, décrit un procédé de fabrication d'une photodiode passivée permettant de limiter le courant d'obscurité. Le courant d'obscurité est lié à la présence d'une zone déplétée située dans le matériau semiconducteur de la photodiode, à l'interface avec la couche diélectrique de passivation. Le procédé de fabrication comporte alors une étape de recuit sous N₂H₂ de la photodiode, permettant de transformer cette zone déplétée en une zone d'accumulation de trous. Cette étape permet alors de réduire l'intensité du courant d'obscurité.

Or, il apparaît que cette étape de recuit, destinée à modifier la zone déplétée en une zone d'accumulation, peut induire une dégradation des performances de la photodiode, notamment du fait d'une modification non souhaitée des dimensions du caisson dopé n+, en particulier lorsque la diffusion latérale des éléments dopants de type n est importante. Par ailleurs, la présence et les caractéristiques de la zone déplétée peuvent être liées à la technique utilisée de dépôt de la couche diélectrique de passivation ainsi qu'aux conditions opératoires. Il en résulte que le recuit en question peut alors ne pas permettre d'obtenir de manière reproductible la zone d'accumulation souhaitée et donc la réduction voulue du courant d'obscurité.

Aussi, le document EP 3 657 556 A1 décrit un exemple de photodiode passivée réalisée à base de germanium comportant un région périphérique dopée p entourant le caisson dopé n+ et affleurant la face de germanium recouverte par la couche diélectrique de passivation. Cette région périphérique dopée p est située entre le caisson dopé n+ et la portion latérale périphérique, et permet de réduire le courant d'obscurité en limitant la composante de surface du courant d'obscurité.

On connaît également le document EP 3 660 930 A1 qui décrit un autre exemple de photodiode passivée réalisée à base de germanium. La couche de passivation n'est pas réalisée en un matériau diélectrique mais est réalisée à base de silicium. Un recuit est effectué pour provoquer une interdiffusion du silicium de la couche de passivation et du germanium de la couche de détection. Ainsi, le caisson dopé n+ est entouré par une zone périphérique à base de SiGe qui forme une « ouverture de gap » permettant de limiter la composante de surface du courant d'obscurité.

On connaît enfin le document EP 3 971 995 A1 qui décrit un autre exemple de photodiode passivée réalisée à base de germanium. Elle comporte une portion périphérique réalisée en un matériau ferroélectrique, située entre et au contact de la région intermédiaire et de la couche diélectrique de passivation, et qui entoure le caisson dopé n+ dans le plan principal. Cette portion périphérique ferroélectrique, par l'orientation voulue des dipôles ferroélectriques lors de la polarisation de la photodiode, permet de limiter ou d'éviter la formation d'une zone déplétée ou d'une zone d'inversion dans la portion de détection, et permet d'éviter la circulation de porteurs de charge dans cette même portion périphérique ferroélectrique, entre le caisson dopé n+ et la région latérale périphérique.

Il existe cependant un besoin de disposer d'une autre solution permettant de réduire le courant d'obscurité dans une photodiode planaire et notamment sa composante de surface située entre le caisson dopé n+ et la portion latérale périphérique.

### EXPOSÉ DE L'INVENTION

L'invention a pour objectif de remédier au moins en partie aux inconvénients de l'art antérieur, et plus particulièrement de proposer une photodiode planaire permettant d'obtenir un faible courant d'obscurité, et notamment de sa composante de surface.

Pour cela, l'objet de l'invention est une photodiode planaire comportant :
- une portion dite de détection d'une couche semiconductrice principale, réalisée en au moins un matériau M0 semiconducteur cristallin à base de germanium, présentant des première et deuxième faces parallèles à un plan principal, et comportant : une première région dopée de type p, affleurant la première face ; une deuxième région dopée de type n, affleurant la deuxième face ; et une région intermédiaire, s'étendant entre les première et deuxième régions dopées, et entourant la deuxième région dopée dans le plan principal en affleurant la deuxième face ;
- une portion latérale périphérique, destinée à être polarisée électriquement, réalisée en au moins un premier matériau M1 électriquement conducteur, s'étendant, suivant un axe vertical orthogonal au plan principal, jusqu'à venir au contact de la première région dopée, et s'étendant au contact de la portion de détection en entourant la région intermédiaire dans le plan principal ; le premier matériau M1 présentant un coefficient de dilatation thermique CTE1 inférieur à celui du matériau M0, s'étendant à partir de la première face, la région intermédiaire comportant une première partie P1, entourée par le premier matériau M1 dans le plan principal, présentant des contraintes mécaniques en tension.

Selon l'invention, la portion latérale périphérique comporte plusieurs matériaux distincts électriquement conducteurs, empilés l'un sur l'autre suivant l'axe vertical, dont: au moins un deuxième matériau M2, s'étendant entre le premier matériau M1 et la deuxième face, présentant un coefficient de dilatation thermique CTE2 supérieur ou égal à celui du matériau M0.

La région intermédiaire comporte alors une deuxième partie P2 affleurant la deuxième face F2, entourée par le deuxième matériau M2 dans le plan principal, formée d'une zone latérale périphérique Z2p présentant des contraintes mécaniques en compression. Cette zone latérale périphérique Z2p entoure une zone centrale Z2c dans le plan principal, présentant des contraintes mécaniques en tension et où se situe la deuxième région dopée.

Certains aspects préférés mais non limitatifs de cette photodiode sont les suivants.

Le premier matériau M1 peut s'étendre, suivant l'axe d'épaisseur de la photodiode, à partir de la première face F1 sur une distance comprise entre 50% et 80% de l'épaisseur de la portion de détection, et le deuxième matériau M2 s'étend, suivant l'axe d'épaisseur de la photodiode, à partir du premier matériau M1 jusqu'à la deuxième face F2 sur une distance comprise entre 20% et 50% de l'épaisseur de la portion de détection.

Le matériau M1 peut être à base de silicium dopé de type p, et le matériau M2 peut être choisi parmi un matériau métallique et un matériau semiconducteur à base de germanium dopé de type p.

La photodiode planaire peut comporter une portion mince intercalaire, réalisée en au moins un matériau métallique, et située entre le matériau M1 à base de silicium dopé de type p et le matériau M2 métallique.

Le premier matériau M1 peut être réalisé à base de silicium dopé de type p et le deuxième matériau M2 peut être réalisé en un matériau métallique, la portion de détection comportant une région latérale dopée de type p s'étendant sur toute la hauteur de la portion latérale périphérique et au contact de cette dernière.

Le premier matériau M1 peut être réalisé à base de silicium dopé de type p, la portion de détection comportant une zone latérale réalisée à base de silicium germanium, s'étendant sur toute la hauteur de la portion latérale périphérique et au contact de cette dernière.

La photodiode planaire peut comporter une couche isolante supérieure, réalisée en un matériau diélectrique, s'étendant sur la deuxième face au contact de la région intermédiaire et au niveau de la zone latérale périphérique Z2p.

L'invention porte également sur un procédé de fabrication d'au moins une photodiode planaire selon l'une quelconque des caractéristiques précédentes, comportant les étapes suivantes :
- réalisation de la couche semiconductrice principale ;
- réalisation d'au moins une tranchée pour former la portion de détection ;
- dépôt du premier matériau M1 à une température de dépôt T1 supérieure à la température ambiante, de manière à remplir la tranchée, puis retour à la température ambiante ;
- réalisation d'au moins une échancrure par gravure partielle du premier matériau M1 ;
- dépôt du deuxième matériau M2 à une température de dépôt T2 supérieure à la température ambiante, de manière à remplir l'échancrure, puis retour à la température ambiante, obtenant ainsi la zone centrale Z2c et la zone latérale périphérique Z2p.

Le procédé peut comporter une étape de réalisation de la deuxième région dopée située dans la zone centrale Z2c.

La couche semiconductrice principale peut être réalisée à partir d'une couche support présentant un coefficient de dilatation thermique inférieur au coefficient CTE0 du matériau M0.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1A est une vue schématique en coupe transversale d'une photodiode planaire selon un mode de réalisation ;
la figure 1B est une vue schématique en coupe transversale d'une photodiode planaire selon une variante de réalisation ;
les figures 2A à 2L illustrent, de manière schématique et partielle, différentes étapes d'un procédé de fabrication d'une matrice de photodiodes planaires identiques ou similaires à celle illustrée sur la fig.1B.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte d'une manière générale sur une photodiode planaire, et de préférence sur une matrice de photodiodes, ainsi que sur un procédé de fabrication d'une telle photodiode. Chaque photodiode comporte une portion de détection réalisée à base de germanium, et est adaptée à détecter un rayonnement lumineux dans le proche infrarouge (SWIR) correspondant à la gamme spectrale allant de 0.8µm à 1.7µm environ, voire à 2.5µm environ. Autrement dit, elle est adaptée à détecter un rayonnement lumineux à une longueur d'onde de coupure supérieure à 1550nm.

La ou les photodiodes sont réalisées à partir d'une même couche semiconductrice principale. Cette dernière s'étend dans un plan principal, et présente une première face et une deuxième face opposées l'une à l'autre et parallèles au plan principal. Les deux faces s'étendent donc suivant des plans identiques pour chacune des photodiodes, et délimitent verticalement (suivant l'axe d'épaisseur) la portion de détection.

Les photodiodes ne présentent pas une structure en mesa dans la mesure où elles sont réalisées à partir de la même couche principale semiconductrice et sont isolées optiquement les unes des autres par une portion latérale périphérique. Elles présentent ainsi un facteur de remplissage particulièrement élevé. Par ailleurs, elles sont ici de préférence passivées dans la mesure où la face où affleure le caisson dopé n+ est au moins en partie recouverte par une couche diélectrique de passivation. Celle-ci contribue à réduire la composante de surface du courant d'obscurité.

Le courant d'obscurité d'une photodiode est le courant électrique présent au sein de la photodiode en fonctionnement, lorsqu'elle n'est pas soumise à un rayonnement lumineux. Il peut être formé de courants générés thermiquement à l'intérieur du volume de la portion de détection (courants de diffusion, courants de déplétion, courants tunnels...) et de courants de surface. Les courants de surface peuvent être liés à la présence de charges électriques dans la couche diélectrique de passivation. En effet, ces charges électriques peuvent induire une modification de la courbure des bandes d'énergie à proximité de la surface, conduisant à la formation d'une zone déplétée ou d'une zone d'inversion. La zone déplétée, lorsqu'elle est située dans la zone de charge d'espace de la photodiode, peut donner lieu à des courants parasites de type génération-recombinaison. Par ailleurs, la zone d'inversion, alors électriquement conductrice, peut permettre le déplacement de charges électriques entre des régions polarisées électriquement et situées à l'interface avec la couche de passivation.

Dans le cadre de l'invention, la photodiode planaire comporte :
∘ une portion dite de détection de la couche semiconductrice principale, réalisée en un matériau M0 semiconducteur cristallin à base de germanium, et comportant : une première région dopée de type p (ici une semelle dopée p+), une deuxième région dopée de type n (ici un caisson dopé n+), et une région intermédiaire située entre les deux régions dopées et entourant le caisson dopé n+ dans le plan principal de la photodiode ;
∘ une portion latérale périphérique, destinée à être polarisée électriquement, s'étendant suivant un axe d'épaisseur de la photodiode jusqu'à venir au contact de la première région dopée de type p, et s'étendant au contact de la portion de détection en entourant la région intermédiaire dans le plan principal, et réalisée en plusieurs matériaux électriquement conducteurs (semiconducteur dopé et/ou métal) empilés l'un sur l'autre suivant l'axe d'épaisseur.

Comme il sera décrit en détail plus loin, la portion latérale périphérique comporte : au moins un premier matériau M1 électriquement conducteur, présentant un coefficient de dilatation thermique CTE1 inférieur au coefficient CTE0 du matériau semiconducteur M0 à base de germanium de la portion de détection ; et au moins un deuxième matériau M2 électriquement conducteur, présentant un coefficient de dilatation thermique CTE2 supérieur ou égal au coefficient CTE0 du matériau semiconducteur M0.

Le premier matériau M1 et le deuxième matériau M2 sont empilés l'un sur l'autre suivant l'axe d'épaisseur de la photodiode, de sorte que le premier matériau M1 s'étend verticalement à partir de la première face, et le deuxième matériau M2 s'étend verticalement entre le premier matériau M1 et la deuxième face. Cet agencement se traduit par la formation, dans la région intermédiaire : d'une première partie P1, entourée par le premier matériau M1 dans le plan principal, et présentant des contraintes mécaniques en tension ; et d'une deuxième partie P2 affleurant la deuxième face F2, entourée par le deuxième matériau M2 dans le plan principal, et, formée d'une zone latérale périphérique Z2p présentant des contraintes mécaniques en compression. Cette zone latérale périphérique Z2p entoure une zone centrale Z2c dans le plan principal, laquelle présente des contraintes mécaniques en tension et où se situe le caisson dopé n+.

Notons que les contraintes mécaniques dont il est question ici sont orientées dans le plan principal de la photodiode. Les contraintes mécaniques entraînent une déformation des mailles du réseau cristallin du matériau contraint. Lorsque le matériau est en compression, respectivement en tension, il présente un paramètre de maille inférieur, respectivement supérieur, à sa valeur naturelle lorsque le matériau est relaxé (non contraint).

Aussi, la présence de cette zone latérale périphérique Z2p de la région intermédiaire où les contraintes mécaniques sont en compression, qui affleure la deuxième face et entoure le caisson dopé n+ dans le plan principal, se traduit par une augmentation locale de l'énergie de bandes interdites (ouverture de gap) du matériau M0 à base de germanium, et donc par une diminution de composante surfacique du courant d'obscurité, ce qui améliore les performances de la photodiode.

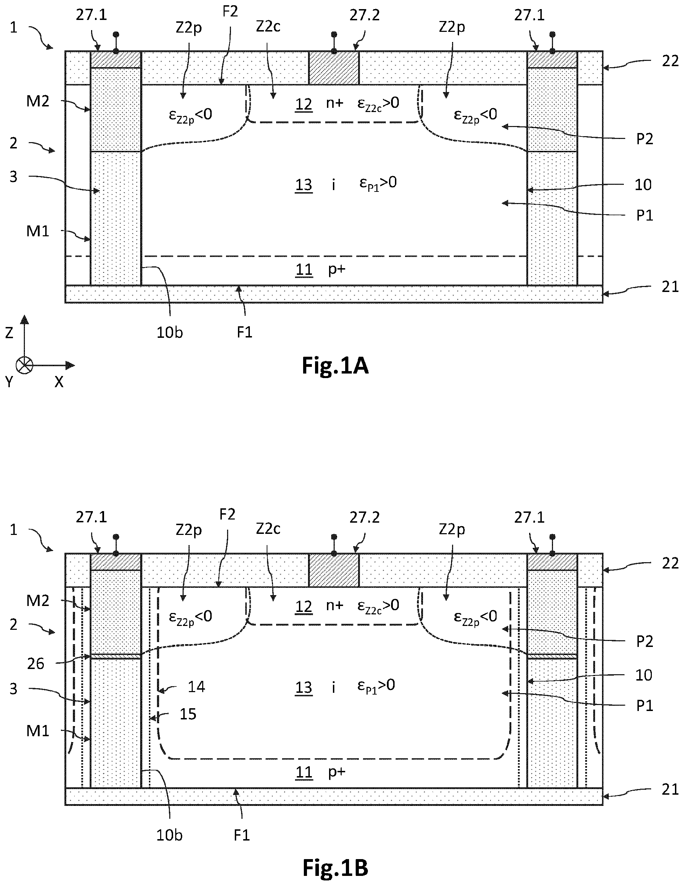

Les figures 1A et 1B sont des vues schématiques et partielles, en coupe transversale, d'une photodiode planaire 1 selon différents modes de réalisation, appartenant à une matrice de photodiodes de préférence identiques.

La photodiode planaire 1 de la fig.1B se distingue essentiellement de celle de la fig.1A en ce que la portion latérale périphérique 3 comporte une portion mince intercalaire 26 située entre et au contact des matériaux M1 et M2, permettant d'améliorer le contact ohmique entre ces matériaux. C'est le cas notamment lorsque le matériau M1 est du polysilicium dopé p+ et que le matériau M2 est du nitrure de titane. La photodiode planaire 1 de la fig.1B se distingue également de celle de la fig.1A par la présence d'une région latérale 14 dopée p et d'une zone latérale 15 en SiGe. Notons que l'une ou l'autre de ces caractéristiques peuvent également être présentes dans la photodiode planaire 1 de la fig.1A.

On définit ici et pour la suite de la description un repère direct tridimensionnel XYZ, où les axes X et Y forment un plan parallèle au plan principal des photodiodes 1, et où l'axe Z est orienté suivant l'épaisseur de la portion de détection 10 de la photodiode 1, à partir de la première face F1 en direction de la deuxième face F2. Les termes « inférieur » et « supérieur » font référence à un positionnement croissant suivant la direction +Z définie sur la fig.1A.

Chaque photodiode 1 est réalisée à base de germanium, et est ici polarisée en inverse à partir de la deuxième face F2, tout en étant optiquement isolées les unes des autres par des portions latérales périphériques 3. Chaque photodiode 1 comporte une portion de détection 10 réalisée à base de germanium, et est adaptée à détecter le rayonnement lumineux dans le proche infrarouge (SWIR).

La photodiode 1 comporte une portion dite de détection 10 d'une couche semiconductrice principale 2, qui s'étend suivant l'axe Z entre une première face F1 et une deuxième face F2. Les faces F1 et F2 sont parallèles entre elles et opposées l'une à l'autre. La première face F1 et la deuxième face F2 sont communes aux photodiodes 1 de la matrice. Dans cet exemple, les faces F1 et F2 sont sensiblement planes.

L'épaisseur de la portion de détection 10, définie suivant l'axe Z entre les première et deuxième faces F1, F2, est ici sensiblement constante d'une photodiode à l'autre, par exemple est comprise entre quelques centaines de nanomètres et quelques microns, par exemple entre 1µm et 5µm environ. L'épaisseur est choisie de manière à obtenir une bonne absorption dans la gamme de longueurs d'onde du rayonnement lumineux à détecter. La portion de détection 10 présente une dimension transversale dans le plan XY pouvant être comprise entre quelques centaines de nanomètres et quelques dizaines de microns, par exemple comprise entre 1µm et 20µm environ.

La portion de détection 10 est réalisée en un matériau semiconducteur cristallin à base de germanium, noté M0, de préférence monocristallin. Par à base de germanium, on entend que le matériau M0 est du germanium ou est un composé (binaire ou ternaire...) formé d'au moins le germanium. Ainsi, la portion de détection 10 peut être réalisée, par exemple, en germanium Ge, en silicium germanium SiGe, en germanium étain GeSn, voire en silicium germanium étain SiGeSn. Elle peut ainsi être réalisée en le même matériau semiconducteur et présenter des régions de différents types de conductivité (homojonction) de manière à former une jonction pn ou pin. Elle peut en variante être un empilement de sous-couches de différents matériaux semiconducteurs (hétérojonction), lesquels sont alors formés à base de germanium.

La portion de détection 10 est ainsi formée d'une première région 11 dopée de type p, qui affleure la première face F1 et forme une « semelle » dopée de type p, et d'une deuxième région 12 dopée de type n, qui affleure la deuxième face F2 et forme un « caisson » dopé de type n. Par affleurer, on entend « arriver au niveau de », ou « s'étend à partir de ». Une région intermédiaire 13 non intentionnellement dopé (dans le cas d'une jonction pin), ou dopée p (dans le cas d'une jonction pn), est située entre et au contact des deux régions dopées 11, 12, et entoure le caisson 12 dopé n+ dans le plan principal. Dans cet exemple, la jonction semiconductrice est de type pin, la semelle 11 étant dopée de type p+, le caisson 12 étant dopé de type n+ et la région intermédiaire 13 étant non intentionnellement dopée.

La semelle 11 dopée p+ s'étend dans le plan XY à partir de la bordure latérale 10b, en affleurant la première face F1. Comme l'illustre la fig.1A, elle peut présenter une épaisseur sensiblement homogène suivant l'axe Z et ainsi affleurer uniquement une zone inférieure de la bordure latérale 10b. En variante, comme l'illustre la fig.1B, la semelle dopée p+ peut également présenter une région latérale 14 dopée p+ qui affleure continûment la bordure latérale 10b suivant l'axe Z et qui s'étend sur toute la périphérie de la portion de détection 10. La semelle 11 dopée p+ peut présenter un dopage pouvant être compris entre 10¹⁸ et 10²⁰ at/cm³ environ.

Le caisson 12 dopé n+ s'étend ici à partir de la deuxième face F2 et est entouré par la région intermédiaire 13 dans le plan principal. Il est distant de la bordure latérale 10b de la portion de détection 10 dans le plan XY dans la mesure où il est entouré latéralement par la région intermédiaire 13. Il peut présenter un dopage pouvant être compris entre 10¹⁹ et 10²¹ at/cm³ environ.

La région intermédiaire 13 est située verticalement entre la semelle dopée p+ et le caisson dopé n+. Elle entoure latéralement le caisson dopé n+ dans le plan principal. Elle est ici réalisée en un matériau semiconducteur non intentionnellement dopé, de manière à former une jonction pin mais peut être dopée selon le deuxième type de conductivité, ici de type p, pour former une jonction pn.

La photodiode 1 comporte de préférence une couche isolante inférieure 21, réalisée en un matériau diélectrique, recouvrant la première face F1 de la portion de détection 10, ainsi que, dans cet exemple, la face inférieure de la portion latérale périphérique 3. La couche isolante inférieure 21 peut en outre être adaptée à former une fonction d'antireflet vis-à-vis du rayonnement lumineux incident. Elle forme en effet la face de réception du rayonnement lumineux destiné à être détecté.

La portion de détection 1 est délimitée latéralement, dans le plan principal, par une tranchée, de préférence continue, remplie de plusieurs matériaux électriquement conducteurs empilés suivant l'axe vertical Z, formant une portion latérale périphérique 3. La portion latérale périphérique 3 participe à polariser électriquement la photodiode 1, ici à partir de la deuxième face F2, et à pixelliser la matrice de photodiodes (isolation optique). Elle s'étend ici sur toute l'épaisseur de la portion de détection 10 pour déboucher sur la couche isolante inférieure 21, mais en variante, elle peut ne pas déboucher sur la couche isolante inférieure 21 et peut se terminer dans la semelle 11 dopée p+. La face interne de cette portion latérale périphérique 3 est au contact de la bordure latérale 10b de la portion de détection 10. Comme détaillé plus loin, la portion latérale périphérique 3 est formée d'au moins un premier matériau M1 électriquement conducteur ayant un coefficient de dilatation thermique CTE1 inférieur au coefficient CTE0 du matériau M0 à base de germanium de la portion de détection 10, et d'au moins un deuxième matériau M2 électriquement conducteur ayant un coefficient de dilatation thermique CTE2 supérieur ou égal au coefficient CTE0 du matériau M0.

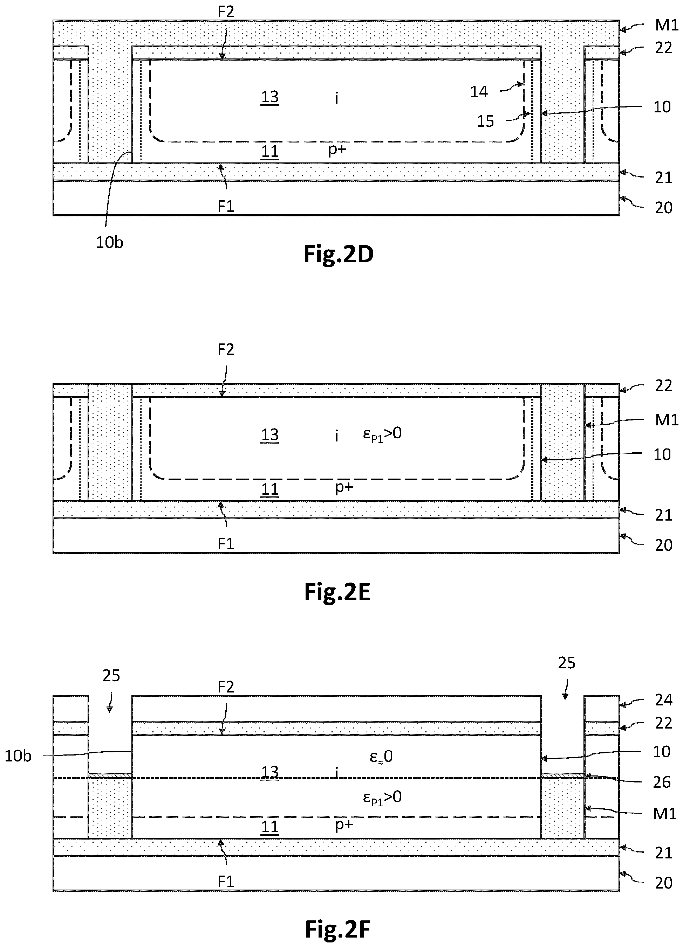

Par ailleurs, comme l'illustre la fig.1B, et dans le cas où le matériau M1 est à base de silicium, la portion de détection 10 comporte avantageusement une région latérale 14 dopée de type p située au niveau de la bordure latérale 10b. Cette région latérale 14 présente un niveau de dopage supérieur à celui de la région intermédiaire 13 lorsqu'elle est dopée. La région latérale 14 dopée p+ affleure la bordure latérale 10b et est au contact ici de la portion latérale périphérique 3. Dans cet exemple, la région latérale 14 s'étend sur toute la hauteur de la portion latérale périphérique 3, même au niveau du deuxième matériau M2. Ceci provient du fait que le matériau M1 a été déposé sur toute la hauteur de la tranchée 23 (cf. fig.2D). Ainsi, la polarisation de la semelle 11 dopée p+ est améliorée dans la mesure où la surface de contact avec la portion latérale périphérique 3 est augmentée. De plus, cette région latérale 14 dopée p+ permet d'éviter que la zone de charge d'espace de la photodiode 1 ne s'étende jusqu'à la bordure latérale 10b. Ainsi, on limite la contribution de cette zone (potentiellement non exempte de défauts liés à la réalisation des tranchées) au courant d'obscurité. On améliore ainsi les performances de la photodiode 1.

Par ailleurs, comme l'illustre également la fig.1B, dans le cas comme ici où la portion de détection 10 est réalisée en germanium, et où le matériau M1 de la portion latérale périphérique 3 est à base de silicium, la portion de détection 10 comporte avantageusement une zone latérale 15 réalisée à base de silicium germanium. La zone latérale 15 affleure la bordure latérale 10b et est au contact de la portion latérale périphérique 3. Dans cet exemple, la zone latérale 15 s'étend sur toute la hauteur de la portion latérale périphérique 3, même au niveau du deuxième matériau M2. Ceci provient du fait que le matériau M1 a été déposé sur toute la hauteur de la tranchée 23 (cf. fig.2D). Ainsi, la zone latérale 15 présente une énergie de bande interdite (gap) supérieure à celle de la portion de détection 10 réalisée en germanium. Cette « ouverture de gap » latérale permet de diminuer la sensibilité de la photodiode 1 aux défauts présents à proximité des tranchées 24. On améliore ainsi également les performances de la photodiode 1.

Une couche isolante supérieure 22 recouvre la deuxième face F2 de la photodiode 1, et permet de passiver le matériau M0 au niveau de la face F2, et d'isoler électriquement les contacts métalliques 32.1 et 32.2. Elle est ainsi au contact du caisson 12 dopé n+ ainsi que de la région intermédiaire 13. Elle est de préférence réalisée en un matériau diélectrique, tel qu'un oxyde de silicium, un nitrure de silicium, ou un oxynitrure de silicium. Il s'agit alors d'une couche diélectrique de passivation. D'autres matériaux diélectriques peuvent être utilisés, tels qu'un oxyde d'hafnium ou d'aluminium, voire un nitrure d'aluminium, entre autres. Elle présente une épaisseur par exemple comprise entre 50nm et 500nm.

La photodiode 1 comporte en outre des contacts métalliques 27.1, 27.2 permettant de la polariser en inverse à partir du côté de la face F2. Ainsi, un contact métallique 27.2 est ici disposé sur et au contact du caisson 12 dopé n+, et permet d'assurer sa polarisation électrique. Un contact métallique 27.1 est ici disposé sur et au contact de la portion latérale périphérique 3, et permet de polariser électriquement la semelle 11 dopée p+. Les contacts métalliques 27.1, 27.2 sont ici isolés électriquement les uns des autres dans le plan XY par la couche isolante supérieure 22. La photodiode 1 est destinée à être polarisée en inverse, par exemple en appliquant un potentiel électrique négatif à la portion latérale périphérique 3 et en portant à la masse le caisson 12 dopé n+.

D'une manière générale, à titre illustratif, la photodiode 1 peut présenter des dimensions dans le plan XY comprises entre 1µm et 100µm environ. L'épaisseur de la semelle 11 dopée p+ peut être comprise entre 20nm et 500nm environ. L'épaisseur de la région intermédiaire 13 peut être comprise entre 0.7µm et 2.5µm environ lorsque la photodiode 1 est destinée à détecter un rayonnement lumineux dans la gamme du SWIR ou du proche infrarouge (NIR). Le caisson 12 dopé n+ peut présenter une profondeur comprise entre 10nm et 600nm environ, par exemple égale à 300nm environ. La couche isolante supérieure 22 peut présenter une épaisseur permettant de recouvrir entièrement la face F2 de la photodiode 1, par exemple comprise entre 10nm et 600nm environ, et l'épaisseur de la couche isolante inférieure 21 peut être comprise entre 50nm et 1µm environ.

Pour réduire la composante de surface du courant d'obscurité, la portion latérale périphérique 3 est formée de plusieurs matériaux électriquement conducteurs (semiconducteurs dopés, métaux...), empilés verticalement suivant l'axe Z et disposés en contact électrique l'un de l'autre, et au contact de la portion de détection. Ils présentent des coefficients de dilatation thermique bien choisis.

L'objectif est ici de générer des contraintes mécaniques différentes au sein de la région intermédiaire 13 : d'une part des contraintes mécaniques en tension dans la zone d'absorption du rayonnement lumineux, c'est-à-dire entre la semelle 11 dopée p+ et le caisson 12 dopé n+, de manière à augmenter la longueur d'onde de coupure d'absorption et ainsi obtenir une photodiode pouvant opérer dans le SWIR ; et d'autre part des contraintes mécaniques en compression dans une zone affleurant la deuxième face F2 et entourant le caisson 12 dopé n+ dans le plan principal, de manière à ouvrir localement le gap et ainsi réduire la composante surfacique du courant d'obscurité.

Le premier matériau M1 et le deuxième matériau M2 sont électriquement conducteurs, dans la mesure où ils participent à assurer la polarisation électrique de la semelle 11 dopée p+ à partir du contact métallique 27.2 situé au niveau de la deuxième face F2. Aussi, le premier matériau M1 et le deuxième matériau M2 peuvent être choisis parmi les semiconducteurs dopés de type p et les métaux. A titre d'exemple, le premier matériau M1 peut être un matériau à base de silicium dopé de type p, par exemple du polysilicium dopé p+. Le deuxième matériau M2 peut être un matériau métallique ou un matériau semiconducteur à base de germanium dopé de type p, par exemple du germanium dopé p+ ou un nitrure de titane, voire encore une combinaison Ti/TiN, Ni/TiN, Ti/Cu ou Ti/TiN/Cu.

Le premier matériau M1 et le deuxième matériau M2 sont empilés l'un sur l'autre suivant l'axe Z. Ils peuvent être au contact l'un de l'autre (cf. fig.1A). C'est le cas notamment lorsque le deuxième matériau M2 est du germanium dopé p+ qui repose sur le matériau M1 en polysilicium dopé p+. En variante, ils peuvent être séparés verticalement l'un de l'autre par une portion mince intercalaire 26 permettant d'améliorer le contact ohmique (cf. fig.1B). C'est le cas notamment lorsque le deuxième matériau M2 est du nitrure de titane qui repose sur le matériau M1 en polysilicium dopé p+. Ils sont également au contact de la bordure latérale 10b de la portion de détection 10, de manière à pouvoir générer les contraintes mécaniques recherchées au sein de la portion de détection 10.

Le premier matériau M1 s'étend à partir de la première face F1 sur une distance suivant la direction +Z de préférence au moins égale à 50% de l'épaisseur de la portion de détection 10, et de préférence sur une distance comprise entre 50% et 80% de cette épaisseur. Le deuxième matériau M2 s'étend à partir du premier matériau M1 jusqu'à la deuxième face F2, sur une distance suivant la direction +Z de préférence au plus égale à 50% de l'épaisseur de la portion de détection 10, et de préférence sur une distance comprise entre 20% et 50% de cette épaisseur, en fonction de la hauteur du premier matériau M1.

Le premier matériau M1 présente un coefficient de dilatation thermique CTE1 inférieur au coefficient CTE0 du matériau semiconducteur M0 à base de germanium de la portion de détection 10. Le deuxième matériau M2 présente un coefficient de dilatation thermique CTE2 supérieur ou égal au coefficient CTE0 du matériau semiconducteur M0.

A titre d'exemple, dans le cas où la portion de détection 10 est réalisée en germanium, le premier matériau M1 peut être réalisé en polysilicium dopé p+, et le deuxième matériau M2 peut être réalisé en nitrure de titane ou en germanium dopé p+. Le coefficient CTE0 du germanium est égal à 5.9 µm/(m×K), celui du silicium est égal à 2.6 µm/(m×K), et celui du nitrure de titane est égal à 9.0 µm/(m×K).

Le fait que la portion latérale périphérique soit réalisée à partir de ce premier matériau M1 et de ce deuxième matériau M2 engendre des contraintes mécaniques différentes au sein de la région intermédiaire 13.

Plus précisément, la région intermédiaire 13 présente une première partie P1, qui est entourée dans le plan XY par le premier matériau M1. Du fait du différentiel de dilatation thermique entre le premier matériau M1 et celui de la région intermédiaire 13, la première partie P1 présente des contraintes mécaniques en tension, alors que le premier matériau M1 présente des contraintes mécaniques en compression.

Les contraintes mécaniques en tension subies localement dans la partie P1 de la région intermédiaire 13 se traduisent alors par une modification locale des propriétés optiques et/ou électriques de la photodiode 1, dont notamment un élargissement de la gamme spectrale d'absorption d'un rayonnement lumineux : la longueur d'onde de coupure d'absorption peut alors être supérieure à 1550nm, de sorte que la photodiode 1 peut alors opérer dans une plus grande gamme spectrale, voire dans toute la gamme spectrale du SWIR. De plus, la mise en contrainte en tension peut également être suffisante pour rendre sensiblement directe la structure de bandes d'énergie du germanium dans la partie P1de la région intermédiaire 13, alors que la structure de bandes du germanium relaxé est indirecte.

De plus, la région intermédiaire 13 présente une deuxième partie P2, qui est entourée dans le plan XY par le deuxième matériau M2. Cette deuxième partie P2 affleure donc la deuxième face F2 et est située au-dessus suivant l'axe Z de la première partie P1. Du fait du différentiel de dilatation thermique entre le deuxième matériau M2 et celui de la région intermédiaire d'une part, et du fait du différentiel de dilatation thermique entre le deuxième matériau M2 et le premier matériau M1 d'autre part, la deuxième partie P2 est formée d'une zone latérale périphérique Z2p, qui affleure la deuxième face F2 et est au contact du deuxième matériau M2, et qui présente des contraintes mécaniques en compression. Il apparaît que cette zone latérale périphérique Z2p entoure une zone centrale Z2c (de la portion de détection 10, pas de la région intermédiaire 13), qui affleure également la deuxième face F2 et présente des contraintes mécaniques en tension. Notons également que le deuxième matériau M2 présente des contraintes mécaniques en tension.

Le caisson 12 dopé n+ est situé principalement dans la zone centrale Z2c, c'est-à-dire qu'il peut être entièrement situé dans la zone centrale Z2c ou peut présenter une bordure latérale qui est située dans la zone latérale périphérique Z2p. Par ailleurs, les contraintes mécaniques restent continûment en tension lorsqu'on va de la zone centrale Z2c vers la partie P1 de la région intermédiaire 13, ce qui permet de maintenir de bonnes performances de la photodiode 1.

La zone latérale périphérique Z2p affleure également la deuxième face F2, et vient latéralement au contact du deuxième matériau M2. Elle entoure la zone centrale Z2c dans le plan principal, et donc également le caisson 12 dopé n+. Elle est située au-dessus de la première partie P1. Dans la mesure où la région intermédiaire 13 présente localement, i.e. dans la zone latérale périphérique Z2p, des contraintes mécaniques en compression, la région intermédiaire 13 y présente une ouverture de gap qui réduit la composante surfacique du courant d'obscurité.

Aussi, par cette configuration de la portion latérale périphérique 3 qui induit des zones de différentes contraintes mécaniques au sein de la région intermédiaire 13, et en particulier la partie P1 en tension et la zone Z2p en compression, la photodiode 1 est alors en mesure de détecter un rayonnement lumineux jusqu'à une longueur d'onde de coupure supérieure à 1550nm, et présente également de bonnes performances du fait de la réduction de la composante surfacique du courant d'obscurité au niveau de la face F2.

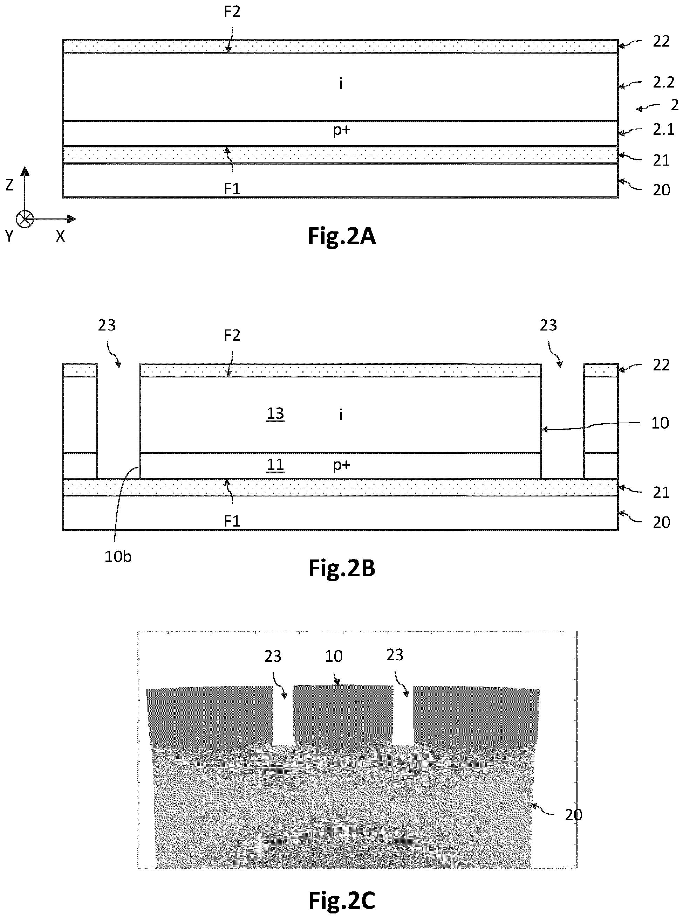

Les figures 2A à 2L illustrent, de manière schématique et partielle, différentes étapes d'un procédé de fabrication d'une matrice de photodiodes planaires 1 identiques ou similaires à celle illustrée sur la fig.1B.

Les photodiodes 1 sont réalisées en germanium et comportent une jonction pin. Elles sont adaptées à détecter un rayonnement infrarouge dans la gamme SWIR. Les photodiodes 1 sont planaires et passivées, et sont polarisées en inverse à partir de la deuxième face F2 par une puce de commande 30 hybridée à la matrice de photodiode.

Lors d'une première étape (fig.2A), on réalise une première sous-couche semiconductrice 2.1 de germanium monocristallin. La première sous-couche semiconductrice 2.1 est solidarisée à une couche support 20, de préférence un substrat épais (*wafer* en anglais) réalisé en un matériau présentant un coefficient de dilatation thermique CTEw inférieur à celui du matériau M0 de ce qui sera la portion de détection 10. Dans cet exemple, la couche support 20 est un substrat en silicium. La première sous-couche semiconductrice 2.1 est assemblée à la couche support 20 par l'intermédiaire de la couche isolante inférieure 21, ici en un oxyde de silicium. Cet empilement prend la forme d'un substrat GeOI (pour *Germanium On Insulator,* en anglais). Cet empilement est de préférence réalisé au moyen du procédé décrit dans la publication de Reboud et al. intitulée Structural and optical properties of 200mm germanium-on-insulotor (GeOI) substrates for silicon photonics applications, Proc. SPIE 9367, Silicon Photonics X, 936714 (February 27, 2015).

Le procédé de Reboud et al. 2015 présente l'avantage de réaliser une sous-couche semiconductrice de germanium 2.1 présentant une absence totale ou un faible taux de défauts structuraux tels que les dislocations. Le germanium peut être non intentionnellement dopé ou être dopé, par exemple de type p. La sous-couche semiconductrice 2.1 peut présenter une épaisseur comprise entre 100nm et 500nm environ, par exemple égale à 300nm environ, et peut être recouverte d'une couche de protection (non représentée) en un oxyde de silicium. La couche isolante inférieure 21 (BOX, pour *Buried Oxide,* en anglais) peut présenter une épaisseur comprise entre 50nm et 1µm, par exemple comprise entre 100nm et 500nm, et assure avantageusement une fonction d'antireflet.

On réalise ensuite un dopage de type p de la première sous-couche 2.1 en germanium, par implantation ionique d'un dopant tel que le bore ou le gallium, lorsque la première sous-couche 2.1 était initialement en germanium intrinsèque. La couche de protection, le cas échéant, a été préalablement retirée par un nettoyage de surface, et la première sous-couche 2.1 de germanium peut être revêtue d'une couche d'oxyde de préimplantation (non représentée) d'une épaisseur de quelques dizaines de nanomètres, par exemple égale à 20nm. La sous-couche 2.1 de germanium présente alors un niveau de dopage compris entre 10¹⁸ et 10²⁰ at/cm³ environ. Un recuit de diffusion du dopant peut ensuite être effectué sous azote, pendant quelques minutes à quelques heures, par exemple 1h, à une température pouvant être comprise entre 600°C et 800°C, par exemple égale à 800°C. Ce recuit peut ne pas être effectué lorsque la sous-couche 2.1 était dopée à la croissance. Une autre manière de fabriquer cette couche p+ est par épitaxie d'une couche de germanium dopé en bore in situ entre 10¹⁸ et 10²⁰ at/cm³ environ sur une sous-couche de germanium intrinsèque. Cette épitaxie peut se faire entre 400 et 800°C mais préférentiellement à 400°C.

On réalise ensuite une deuxième sous-couche semiconductrice 2.2 de germanium par épitaxie à partir de la première sous-couche 2.1. Les deux sous-couches 2.1, 2.2 sont destinées à former la couche semiconductrice principale 2 ainsi que les portions de détection 10. La deuxième sous-couche 2.2 est formée par épitaxie, par exemple par dépôt chimique en phase vapeur (CVD, pour *Chemical Vapor Deposition,* en anglais) et de précédence en pression réduite (RPCVD, pour *Reduced Pressure Chemical Vapor Deposition*) ou par toute autre technique d'épitaxie. Des recuits peuvent être effectués pour diminuer le taux de dislocations dans la sous-couche 2.2. La couche d'oxyde de préimplémentation, le cas échéant, a été préalablement retirée par un nettoyage de surface. La deuxième sous-couche 2.2 de germanium est ici intrinsèque, c'est-à-dire non intentionnellement dopée dans la mesure où l'on souhaite réaliser une jonction pin. Elle est destinée à former la zone d'absorption lumineuse des photodiodes 1. Son épaisseur dépend de la gamme de longueurs d'onde du rayonnement lumineux à détecter dans le cas d'une photodiode 1. Dans le cadre de photodiodes SWIR, la sous-couche 2.2 de germanium intrinsèque présente une épaisseur par exemple comprise entre 0,5µm et 3µm, de préférence égale à 1,5µm.

On dépose ensuite une couche isolante supérieure 22 de manière à recouvrir continûment la face supérieure de la deuxième sous-couche 2.2, c'est-à-dire de manière à recouvrir ce que seront les portions de détection 10 des photodiodes 1. La couche isolante supérieure 3 est réalisée en un matériau diélectrique, par exemple un oxyde, un nitrure ou un oxynitrure de silicium. Un nettoyage de la face supérieure de la deuxième sous-couche 2.2 peut avoir été effectué au préalable. La couche isolante supérieure 22 peut présenter une épaisseur comprise entre 10nm et 600nm.

En référence à la fig.2B, on réalise, par photolithographie et gravure, les tranchées 23 destinées à pixelliser les photodiodes 1 et à participer à les polariser électriquement en inverse par les portions latérales périphériques 3. On réalise ainsi une gravure localisée de la couche isolante supérieure 22, de la sous-couche 2.2 de germanium intrinsèque, et de la sous-couche 2.1 de germanium dopé p+, jusqu'à déboucher ici sur la face supérieure de la couche isolante inférieure 21 (mais les tranchées 23 peuvent déboucher sur la sous-couche 2.1 sans la traverser). Chaque tranchée 23 s'étend ainsi de préférence continûment autour d'une photodiode 1. On obtient ainsi une pluralité de portions de détection 10 séparées les unes des autres par une tranchée continue 23. Elles sont obtenues de préférence par une technique de gravure anisotrope, de manière à obtenir une bordure latérale 10b sensiblement verticale suivant l'axe Z. Les tranchées 23 présentent une dimension transversale (largeur) dans le plan XY pouvant être comprise entre 300nm et 2µm, par exemple égale à 1µm. Les portions de détection 10 peuvent ainsi présenter une forme dans le plan XY par exemple circulaire, ovale, polygonale, par exemple carrée, ou toute autre forme.

En référence aux fig. 2C à 2E, on commence la réalisation des portions latérales périphériques 3 par le dépôt du premier matériau M1 à haute température.

Pour cela, comme l'illustre la fig.2C, on porte la structure à une température de dépôt T1 supérieure à la température ambiante, par exemple à quelques centaines de degrés Celsius, comme par exemple au moins égale à 500°C environ, par exemple à 650°C dans le cas ici du dépôt de silicium. Du fait de la présence des tranchées 23, le germanium des portions de détection 10 se dilate dans le plan XY. Cette dilatation du germanium s'accompagne ici d'une mise en courbure de la couche principale 2 du fait du différentiel de dilatation thermique entre le silicium du substrat 20 et le germanium de la couche principale 2.

Notons que la fig.2C illustre le champ de déformations dans le plan principal de la structure alors portée à 650°C. Ces résultats sont issus d'une simulation numérique effectuée à l'aide du logiciel COMSOL. Dans cet exemple, les tranchées 23 sont profondes de 2.3µm et larges de 1µm, et la portion de détection 10 en germanium présente une largeur de 4µm. Le germanium repose sur une couche 20 en silicium d'une épaisseur de 10µm (ici pour diminuer les temps de calcul). Mais la couche de Si a de préférence une épaisseur de 725µm (*Bulk Silicium*). Il apparaît que le germanium présente ici une déformation maximale en tension de l'ordre de 0.65%.

Comme l'illustre la fig.2D, on effectue la croissance par épitaxie du premier matériau M1, ici du silicium dopé p+, dans la tranchée 23, et ici à partir de la surface libre de la bordure latérale 10b des portions de détection 10. Dans la mesure où le premier matériau M1 est ici du silicium, la croissance par épitaxie s'accompagne d'une formation de la région latérale 14 à base de SiGe et de la zone latérale 15. Le silicium épitaxié croît à partir de la surface libre de germanium et remplit les tranchées 23. Il est donc au contact de la bordure latérale 10b des portions de détection 10. Il est déposé de manière à dépasser des tranchées 23 et recouvre ainsi en partie la couche isolante supérieure 22.

A la suite de l'étape d'épitaxie, la température est ramenée à une température finale inférieure à la température d'épitaxie, par exemple à la température ambiante, par exemple à 25°C, ce qui provoque la mise en tension du germanium des portions de détection 10, ainsi que la mise en compression du premier matériau M1.

Le matériau M1 est de préférence un matériau à base de silicium, par exemple du silicium amorphe, du silicium polycristallin, de silicium germanium. Le matériau M1 est dopé selon le deuxième type de conductivité, ici de type p au bore ou au gallium, avec une concentration de dopants de l'ordre de 10¹⁹ à 10²⁰ at/cm³ environ.

Comme l'illustre la fig.2E, une étape de polissage mécanochimique (CMP) est ensuite effectuée, avec arrêt sur la face supérieure de la couche isolante supérieure 23, pour éliminer le matériau M1 en excès et planariser la face supérieure formée par la couche isolante supérieure 23 et le premier matériau M1. On obtient ainsi une portion latérale périphérique qui est pour le moment entièrement remplie par le premier matériau M1 en silicium dopé p+.

En référence aux fig. 2F à 2I, on continue la réalisation des portions latérales périphériques 3 par le dépôt du deuxième matériau M2 à haute température.

Pour cela, comme l'illustre la fig.2F, on réalise une gravure partielle du premier matériau M1 pour former une échancrure 25. Une échancrure 25 est ici une tranchée non traversante, débouchant sur une partie non gravée du matériau M1. Un masque de gravure 24 en résine est déposé sur la couche isolante supérieure 22 de manière à laisser libre le premier matériau M1. Ensuite, le premier matériau M1 est ainsi gravé de manière à rendre libre une surface de la bordure latérale 10b de la portion de détection 10. Le premier matériau M1 est gravé partiellement suivant l'axe Z, jusqu'à une profondeur prédéfinie de sorte que le premier matériau M1 s'étende à partir de la première face F1 sur une distance au moins égale à 50% de l'épaisseur de la portion de détection 10.

A la suite de cette étape de gravure partielle du matériau M1, la région intermédiaire 13 présente une partie P1, entourée par le matériau M1, qui présente des contraintes mécaniques en tension, surmontée par une partie P2, entourée par l'échancrure 25, où le germanium est alors sensiblement relaxé.

Dans le cas où le deuxième matériau M2 est du TiN, il peut être avantageux de former ensuite une portion mince intercalaire 26 de quelques nanomètres de Ni ou de Ti recouvrant la surface supérieure du premier matériau M1. Le deuxième matériau M2 est alors en contact électrique avec le matériau M1 par l'intermédiaire de la portion mince intercalaire 26. Celle-ci permet d'améliorer le contact ohmique entre les matériaux M1 et M2. Dans le cas où le matériau M2 est du germanium dopé p+, une telle couche mince intercalaire 26 peut être omise.

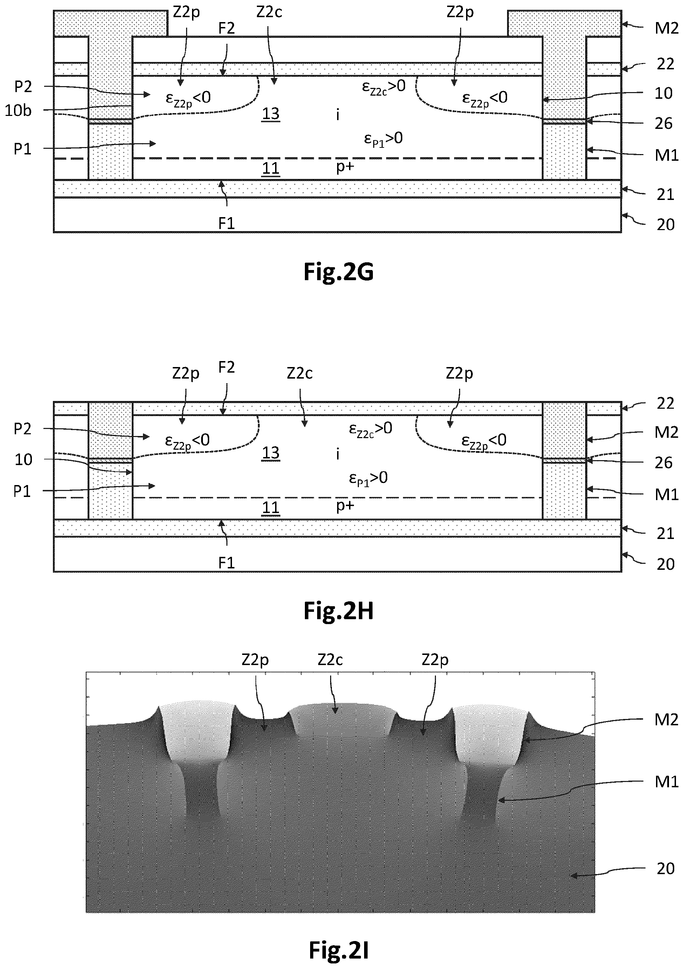

Comme l'illustre la fig.2G, on effectue ensuite la croissance par épitaxie du deuxième matériau M2 dans l'échancrure 25, à partir du premier matériau M1 et de la surface libre de la bordure latérale 10b de la portion de détection 10. Le matériau M2 est déposé de manière à remplir entièrement les échancrures 25, et il recouvre ici au moins en partie la couche isolante supérieure 22. La température de dépôt T2 est supérieure à la température ambiante, par exemple à quelques centaines de degrés Celsius, par exemple au moins égale à 300°C ou 400°C dans le cas du TiN, ou au moins égale à 500°C dans le cas du germanium dopé p+.

A la suite de l'étape d'épitaxie, la température est ramenée à une température finale inférieure à la température d'épitaxie, par exemple à la température ambiante, par exemple à 25°C, ce qui provoque la formation, dans la partie P2 de la région intermédiaire 13, de la zone centrale Z2c en tension et de la zone latérale périphérique Z2p en compression. Le matériau M2 est alors en tension. Notons que dans le cas où le matériau M2 est un semiconducteur dopé, comme du germanium dopé p+, le dopage peut être effectué à la croissance ou après le dépôt par implantation ionique.

Comme l'illustre la fig.2H, une étape de polissage mécanochimique (CMP) est ensuite effectuée, avec arrêt sur la face supérieure de la couche isolante supérieure 22, pour éliminer le matériau M2 en excès et planariser la face supérieure formée par la couche isolante supérieure 22. On obtient ainsi, dans cet exemple, une portion latérale périphérique 3 qui est formée par le matériau M1 en silicium dopé p+ surmonté du matériau M2 ici en TiN.

La fig.2I illustre le champ de déformations dans le plan principal de la structure alors portée à 650°C, laquelle est similaire à celle de la fig.2C. Dans cet exemple, le matériau M1 en polysilicium dopé p+ s'étend sur une hauteur de 1.7µm et le matériau M2 en TiN s'étend sur une hauteur de 0.8µm. Le germanium est alors en tension dans la partie P1 de la région intermédiaire 13 (et le matériau M1 est en compression), et en tension dans la zone centrale Z2c tout en étant en compression dans la zone latérale périphérique Z2p (et le matériau M2 est en tension).

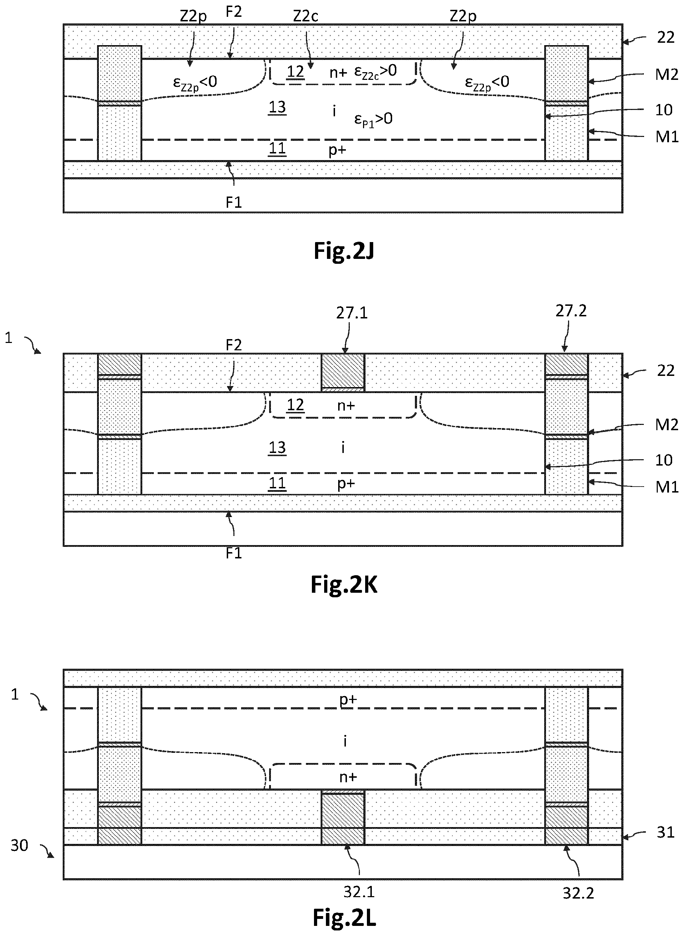

Lors d'une étape suivante (fig.2J), on réalise le caisson 12 dopé n+. Pour cela, on dépose une couche de protection en un matériau diélectrique, par exemple en un oxyde de silicium, d'une épaisseur par exemple comprise entre 10nm et 30nm environ (cette couche de protection et la couche isolante supérieure forment ensemble la couche 22). Ensuite, par photolithographie, on définit dans une résine photosensible (non représentée) une ouverture correspondant à une zone d'implantation définissant le caisson 12 dopé n+. On effectue ensuite une implantation ionique d'un dopant tel que le phosphore ou de l'arsenic, au travers des ouvertures. Le caisson 12 est de préférence surdopé n+, et peut ainsi présenter un niveau de dopage compris entre 5.10¹⁸ et 3.10²⁰ at/cm³ environ. Le caisson 12 dopé n+ est délimité dans le plan XY et suivant l'axe Z par la région intermédiaire 13. Après retrait de la résine photosensible, un recuit de diffusion des dopants peut être effectué. Notons ici que le caisson 12 dopé n+ est principalement situé dans la zone centrale Z2c. Il est ici entièrement situé dans la zone centrale Z2c, mais il est possible que sa bordure latérale soit située dans la zone latérale périphérique Z2p (cf. fig.1A et 1B).

Notons que le caisson 12 dopé n+ peut également être réalisé, non pas par implantation ionique, mais par diffusion de dopants à partir d'un plot de germanium dopé p réalisé par épitaxie localisée sur la face F2. On améliore ainsi la qualité cristalline du germanium dans la portion de détection 10.

Lors d'une étape suivante (fig.2K), on réalise ensuite des ouvertures par gravure localisée de la couche isolante supérieure 22, qui débouchent sur le caisson 12 dopé n+ et sur la portion latérale périphérique 3. Des métallisations de contact 27 sont ensuite réalisées dans les ouvertures, qui peuvent être formées d'une gaine en Ti/TiN et d'un cœur en tungstène W ou en cuivre. Pour cela, une couche mince métallique est déposée dans les ouvertures de manière conforme, par exemple formée d'une sous-couche de titane Ti d'une épaisseur de 5nm environ puis d'une sous-couche de nitrure de titane TiN d'une épaisseur de 10nm environ. Un recuit est effectué de manière à améliorer le contact électrique entre le titane et le germanium du caisson 12 dopé n+, et entre le titane et la portion latérale périphérique 3 lorsqu'elle est réalisée en germanium. Lors de ce recuit, les dopants du caisson 12 dopé n+ peuvent diffuser de sorte que celui-ci occupe un volume plus important dans la portion de détection 10. Une couche métallique, par exemple réalisée en tungstène W ou en cuivre Cu, est ensuite déposée de manière à remplir les ouvertures. Une étape de polissage mécano-chimique est ensuite effectuée, avec arrêt sur la couche isolante supérieure 22. On obtient ainsi des métallisations de contact 27.1 et 27.2 formées d'une gaine en Ti/TiN et d'un cœur en W ou en Cu.

Lors d'une étape suivante (fig.2L), on effectue l'hybridation de la matrice de photodiodes 1 ainsi obtenues sur une puce de commande 30. La face de connexion de la puce de commande 30 peut ainsi être revêtue d'une couche isolante 31, réalisée en un matériau diélectrique, traversée par des métallisations de contact 32.1, 32.2. La matrice de photodiodes 1 et la puce de commande 30 sont ainsi assemblées par adhésion moléculaire hybride. Un recuit de collage peut être effectué de manière à augmenter l'énergie de collage surfacique entre les deux faces en contact. On réalise ensuite la suppression de la couche support 20, par exemple par meulage (*grinding*), de manière à exposer une face de la couche isolante inférieure 21. Celle-ci forme ainsi la face de réception du rayonnement lumineux à détecter.

Le procédé de fabrication permet ainsi d'obtenir une ou plusieurs photodiodes 1 planaires passivées, qui présentent des performances améliorées, du fait de la réduction de la composante de surface du courant d'obscurité au niveau de la face F2 entre le caisson 12 dopé n+ et la portion latérale périphérique 3. La portion de détection 10 est mise en tension dans la partie P1 et mise localement en compression dans la zone Z2p, à la suite des étapes de dépôt à haute température des matériaux M et M2 de la portion latérale périphérique 3, du fait des différentiels de dilatation thermique.

Des modes de réalisation particuliers viennent d'être décrits. Différentes variantes et modifications apparaîtront à l'homme du métier.

## Revendications

1. Photodiode planaire (1), comportant :
∘ une portion dite de détection (10) d'une couche semiconductrice principale (2), réalisée en au moins un matériau M0 semiconducteur cristallin à base de germanium, présentant des première et deuxième faces (F1, F2) parallèles à un plan principal, et comportant : une première région (11) dopée de type p, affleurant la première face (F1) ; une deuxième région (12) dopée de type n, affleurant la deuxième face (F2) ; et une région intermédiaire (13), s'étendant entre les première et deuxième régions dopées (11, 12), et entourant la deuxième région dopée (12) dans le plan principal en affleurant la deuxième face (F2) ;
∘ une portion latérale périphérique (3), destinée à être polarisée électriquement, réalisée en au moins un premier matériau M1 électriquement conducteur, s'étendant, suivant un axe vertical orthogonal au plan principal, jusqu'à venir au contact de la première région dopée (11), et s'étendant au contact de la portion de détection (10) en entourant la région intermédiaire (13) dans le plan principal ;
• le premier matériau M1 présentant un coefficient de dilatation thermique CTE1 inférieur à celui du matériau M0, s'étendant à partir de la première face (F1),
▪ la région intermédiaire (13) comportant une première partie P1, entourée par le premier matériau M1 dans le plan principal, présentant des contraintes mécaniques en tension ;
∘ **caractérisé en ce que** : la portion latérale périphérique (3) comporte plusieurs matériaux distincts électriquement conducteurs, empilés l'un sur l'autre suivant l'axe vertical, dont :
• au moins un deuxième matériau M2, s'étendant entre le premier matériau M1 et la deuxième face (F2), présentant un coefficient de dilatation thermique CTE2 supérieur ou égal à celui du matériau M0,
▪ la région intermédiaire (13) comportant une deuxième partie P2 affleurant la deuxième face F2, entourée par le deuxième matériau M2 dans le plan principal, formée d'une zone latérale périphérique Z2p présentant des contraintes mécaniques en compression, laquelle entoure dans le plan principal une zone centrale Z2c présentant des contraintes mécaniques en tension et où se situe la deuxième région dopée (12).

2. Photodiode planaire (1) selon la revendication 1, dans laquelle le premier matériau M1 s'étend, suivant l'axe d'épaisseur de la photodiode, à partir de la première face F1 sur une distance comprise entre 50% et 80% de l'épaisseur de la portion de détection (10), et le deuxième matériau M2 s'étend, suivant l'axe d'épaisseur de la photodiode, à partir du premier matériau M1 jusqu'à la deuxième face F2 sur une distance comprise entre 20% et 50% de l'épaisseur de la portion de détection (10).

3. Photodiode planaire (1) selon la revendication 1 ou 2, dans laquelle le matériau M1 est à base de silicium dopé de type p, et le matériau M2 est choisi parmi un matériau métallique et un matériau semiconducteur à base de germanium dopé de type p.

4. Photodiode planaire (1) selon l'une quelconque des revendications 1 à 3, comportant une portion mince intercalaire, réalisée en au moins un matériau métallique, et située entre le matériau M1 à base de silicium dopé de type p et le matériau M2 métallique.

5. Photodiode planaire (1) selon l'une quelconque des revendications 1 à 4, dans laquelle le premier matériau M1 est réalisé à base de silicium dopé de type p et le deuxième matériau M2 est réalisé en un matériau métallique, la portion de détection (10) comportant une région latérale (14) dopée de type p s'étendant sur toute la hauteur de la portion latérale périphérique (3) et au contact de cette dernière.

6. Photodiode planaire (1) selon l'une quelconque des revendications 1 à 5, dans laquelle le premier matériau M1 est réalisé à base de silicium dopé de type p, la portion de détection (10) comportant une zone latérale (15) réalisée à base de silicium germanium, s'étendant sur toute la hauteur de la portion latérale périphérique (3) et au contact de cette dernière.

7. Photodiode planaire (1) selon l'une quelconque des revendications 1 à 6, comportant une couche isolante supérieure (22), réalisée en un matériau diélectrique, s'étendant sur la deuxième face (F2) au contact de la région intermédiaire (13) et au niveau de la zone latérale périphérique Z2p.

8. Procédé de fabrication d'au moins une photodiode planaire (1) selon l'une quelconque des revendications 1 à 7, comportant les étapes suivantes :
∘ réalisation de la couche semiconductrice principale (2) ;
∘ réalisation d'au moins une tranchée (23) pour former la portion de détection (10) ;
∘ dépôt du premier matériau M1 à une température de dépôt T1 supérieure à la température ambiante, de manière à remplir la tranchée (23), puis retour à la température ambiante ;
∘ réalisation d'au moins une échancrure (25) par gravure partielle du premier matériau M1 ;
∘ dépôt du deuxième matériau M2 à une température de dépôt T2 supérieure à la température ambiante, de manière à remplir l'échancrure (25), puis retour à la température ambiante, obtenant ainsi la zone centrale Z2c et la zone latérale périphérique Z2p.

9. Procédé de fabrication selon la revendication 8, comportant une étape de réalisation de la deuxième région dopée (12) située dans la zone centrale Z2c.

10. Procédé de fabrication selon la revendication 8 ou 9, dans lequel la couche semiconductrice principale (2) est réalisée à partir d'une couche support (20) présentant un coefficient de dilatation thermique inférieur au coefficient CTE0 du matériau M0.

## Patentansprüche

1. Planare Photodiode (1), umfassend:
∘ einen sogenannten Erfassungsabschnitt (10) einer Haupthalbleiterschicht (2), die aus mindestens einem kristallinen Halbleitermaterial M0 auf Germaniumbasis besteht und eine erste und eine zweite Fläche (F1, F2) aufweist, die parallel zu einer Hauptebene verlaufen, und umfassend: eine erste p-dotierte Region (11), die mit der ersten Fläche (F1) bündig ist; eine zweite n-dotierte Region (12), die mit der zweiten Fläche (F2) bündig ist; und eine Zwischenregion (13), die sich zwischen der ersten und der zweiten dotierten Region (11, 12) erstreckt und die zweite dotierte Region (12) in der Hauptebene bündig mit der zweiten Fläche (F2) umgibt;
∘ einen peripheren Seitenabschnitt (3), der dazu bestimmt ist, elektrisch polarisiert zu werden, und aus mindestens einem ersten elektrisch leitfähigen Material M1 besteht, der sich entlang einer vertikalen Achse senkrecht zur Hauptebene bis zum Kontakt mit der ersten dotierten Region (11) erstreckt und sich in Kontakt mit dem Erfassungsabschnitt (10) erstreckt, der die Zwischenregion (13) in der Hauptebene umgibt;
• das erste Material M1 einen niedrigeren Wärmeausdehnungskoeffizienten CTE1 aufweist als das Material M0, das sich von der ersten Fläche (F1) aus erstreckt,
▪ die dazwischenliegende Region (13) einen ersten Teil P1 umfasst, der von dem ersten Material M1 in der Hauptebene umgeben ist und mechanische Zugspannungen aufweist;
∘ **dadurch gekennzeichnet, dass** der seitliche Abschnitt (3) mehrere unterschiedliche elektrisch leitende Materialien umfasst, die entlang der vertikalen Achse übereinander gestapelt sind, darunter:
• mindestens ein zweites Material M2, das sich zwischen dem ersten Material M1 und der zweiten Fläche (F2) erstreckt und einen Wärmeausdehnungskoeffizienten CTE2 aufweist, der größer oder gleich dem des Materials M0 ist,
▪ die Zwischenregion (13) einen zweiten Teil P2 einschließt, der mit der zweiten Fläche F2 bündig ist und in der Hauptebene von dem zweiten Material M2 umgeben ist, das von einer peripheren seitlichen Zone Z2p mit mechanischen Kompressionsspannungen gebildet wird, die in der Hauptebene eine mittlere Zone Z2c mit mechanischen Zugspannungen umgibt, in der sich die zweite dotierte Region (12) befindet.

2. Planare Photodiode (1) nach Anspruch 1, wobei sich das erste Material M1 entlang der Dickenachse der Photodiode von der ersten Fläche F1 über einen Abstand erstreckt, der zwischen 50 % und 80 % der Dicke des Erfassungsabschnitts (10) umfasst, und sich das zweite Material M2 entlang der Dickenachse der Photodiode von dem ersten Material M1 zu der zweiten Fläche F2 über einen Abstand erstreckt, der zwischen 20 % und 50 % der Dicke des Erfassungsabschnitts (10) umfasst.

3. Planare Photodiode (1) nach Anspruch 1 oder 2, wobei das Material M1 auf p-dotiertem Silizium basiert und das Material M2 aus einem metallischen Material und einem Halbleitermaterial auf Basis von p-dotiertem Germanium ausgewählt ist.

4. Planare Photodiode (1) nach einem der Ansprüche 1 bis 3, die einen dazwischenliegenden dünnen Abschnitt einschließt, der aus mindestens einem metallischen Material besteht und zwischen dem p-dotierten Material auf Siliziumbasis M1 und dem metallischen Material M2 angeordnet ist.

5. Planare Photodiode (1) nach einem der Ansprüche 1 bis 4, wobei das erste Material M1 aus p-dotiertem Silizium und das zweite Material M2 aus einem metallischen Material besteht und der Erfassungsabschnitt (10) eine p-dotierte laterale Region (14) einschließt, die sich über die gesamte Höhe des peripheren lateralen Abschnitts (3) erstreckt und mit diesem in Kontakt steht.

6. Planare Photodiode (1) nach einem der Ansprüche 1 bis 5, wobei das erste Material M1 aus p-dotiertem Silizium besteht und der Erfassungsabschnitt (10) eine laterale Region (15) aus Silizium-Germanium einschließt, die sich über die gesamte Höhe des peripheren lateralen Abschnitts (3) erstreckt und mit diesem in Kontakt steht.

7. Planare Photodiode (1) nach einem der Ansprüche 1 bis 6, die eine obere Isolierschicht (22) aus einem dielektrischen Material einschließt, die sich auf der zweiten Fläche (F2) in Kontakt mit der dazwischenliegenden Region (13) und der peripheren lateralen Zone Z2p erstreckt.

8. Verfahren zur Herstellung mindestens einer planaren Photodiode (1) nach einem der Ansprüche 1 bis 7, das die folgenden Schritte einschließt:
∘ Erzeugen der wichtigsten Halbleiterschicht (2);
∘ Herstellen mindestens eines Grabens (23) zur Formung des Erfassungsabschnitts (10);
∘ Aufbringen des ersten Materials M1 bei einer Ablagerungstemperatur T1 oberhalb der Umgebungstemperatur, um den Graben (23) zu füllen, dann Rückkehr zur Umgebungstemperatur;
∘ Herstellen mindestens einer Kerbe (25) durch teilweises Ätzen des ersten Materials M1;
∘ Aufbringen des zweiten Materials M2 bei einer Temperatur T2 oberhalb der Raumtemperatur, um die Einkerbung (25) auszufüllen, und anschließende Rückkehr zur Umgebungstemperatur, sodass die zentrale Zone Z2c und die seitliche Randzone Z2p erhalten werden.

9. Verfahren zur Herstellung nach Anspruch 8, das den Schritt des Erstellens der zweiten dotierten Region (12) in der zentralen Zone Z2c einschließt.

10. Verfahren zur Herstellung nach Anspruch 8 oder 9, wobei die Haupthalbleiterschicht (2) aus einer Stützschicht (20) hergestellt ist, die einen Wärmeausdehnungskoeffizienten aufweist, der kleiner als der Koeffizient CTE0 des Materials M0 ist.

## Claims

1. Planar photodiode (1), comprising:
∘ a detection portion (10) of a main semiconductor layer (2), produced from at least one germanium-based crystalline semiconductor material M0, having first and second faces (F1, F2) parallel to a main plane, and comprising: a p-doped first region (11) flush with the first face (F1); an n-doped second region (12) flush with the second face (F2); and an intermediate region (13) extending between the first and second doped regions (11, 12) and surrounding the doped second region (12) in the main plane while fitting flush with the second face (F2);
∘ a peripheral lateral portion (3) intended to be electrically biased, produced from at least one first electrically conductive material M1 extending, along a vertical axis orthogonal to the main plane, until it comes into contact with the first doped region (11), and extending in contact with the detection portion (10) while surrounding the intermediate region (13) in the main plane;
• the first material M1 having a coefficient of thermal expansion CTE1 lower than that of the material M0, extending from the first face (F1),
▪ the intermediate region (13) comprising a first part P1 surrounded by the first material M1 in the main plane, having mechanical tensile stresses;
∘ **characterised in that**: the peripheral lateral portion (3) comprises a plurality of distinct electrically conductive materials, stacked one on the other along the vertical axis, among them:
• at least one second material M2, extending between the first material M1 and the second face (F2), having a coefficient of thermal expansion CTE2 higher than or equal to that of the material M0,
▪ the intermediate region (13) comprising a second part P2 fitting flush with the second face F2, surrounded by the second material M2 in the main plane, formed by a peripheral lateral zone Z2p having mechanical compressive stresses, which surrounds in the main plane a central zone Z2c having mechanical tensile stresses and where the second doped region (12) is located.

2. Planar photodiode (1) according to claim 1, wherein the first material M1 extends, along the thickness axis of the photodiode, from the first face F1 over a distance of between 50% and 80% of the thickness of the detection portion (10), and the second material M2 extends, along the thickness axis of the photodiode, from the first material M1 as far as the second face F2 over a distance of between 20% and 50% of the thickness of the detection portion (10).

3. Planar photodiode (1) according to claim 1 or 2, wherein the material M1 is based on p-doped silicon, and the material M2 is selected from a metal material and a semiconductor material based on p-doped germanium.

4. Planar photodiode (1) according to any one of claims 1 to 3, comprising an intermediate end portion produced from at least one metal material and located between the material M1 based on p-doped silicon and the metal material M2.

5. Planar photodiode (1) according to any one of claims 1 to 4, wherein the first material M1 is produced from p-doped silicon and the second material M2 is produced from a metal material, the detection portion (10) comprising a p-doped lateral region (14) extending over the entire height of the peripheral lateral portion (3) and in contact with the latter.

6. Planar photodiode (1) according to any one of claims 1 to 5, wherein the first material M1 is produced from p-doped silicon, the detection portion (10) including a lateral zone (15) produced from silicon germanium, extending over the entire height of the peripheral lateral portion (3) and in contact with the latter.

7. Planar photodiode (1) according to any one of claims 1 to 6, including an upper insulating layer (22) produced from a dielectric material, extending over the second face (F2) in contact with the intermediate region (13) and at the peripheral lateral zone Z2p.

8. Method for manufacturing at least one planar photodiode (1) according to any one of claims 1 to 7, comprising the following steps:
∘ producing the main semiconductor layer (2);
∘ producing at least one trench (23) to form the detection portion (10);
∘ depositing the first material M1 at a deposition temperature T1 higher than ambient temperature, so as to fill the trench (23), and then returning to ambient temperature;
∘ producing at least one recess (25) by partial etching of the first material M1;
∘ depositing the second material M2 at a deposition temperature T2 higher than ambient temperature, so as to fill the recess (25), and then returning to ambient temperature, thus obtaining the central zone Z2c and the peripheral lateral zone Z2p.

9. Manufacturing method according to claim 8, including a step of producing the second doped region (12) located in the central zone Z2c.

10. Manufacturing method according to claim 8 or 9, wherein the main semiconductor layer (2) is produced from a support layer (20) having a coefficient of thermal expansion lower than the coefficient CTE0 of the material M0.
